# EUROPEAN PATENT SPECIFICATION

(11) **EP 4 379 722 B1**
(45) Date of publication and mention of the grant of the patent: **28.01.2026**
(21) Application number: 22211138.7
(22) Date of filing: 02.12.2022
(51) Int. Cl.: G11C 11/22, H10B 51/30

(54) **CAPACITIVE MEMORY STRUCTURE AND METHOD FOR READING-OUT A CAPACITIVE MEMORY STRUCTURE**
KAPAZITIVE SPEICHERSTRUKTUR UND VERFAHREN ZUM AUSLESEN EINER KAPAZITIVEN SPEICHERSTRUKTUR
STRUCTURE DE MÉMOIRE CAPACITIVE ET PROCÉDÉ DE LECTURE D'UNE STRUCTURE DE MÉMOIRE CAPACITIVE

(43) Date of publication of application: 05.06.2024
(73) Proprietor: IMEC VZW, 3001 Leuven (BE); Katholieke Universiteit Leuven, 3000 Leuven (BE)
(72) Inventor: Van Houdt, Jan, 3001 Leuven (BE); Mukherjee, Shanka, 3001 Leuven (BE); Clima, Sergiu, 3001 Leuven (BE); Bizindavyi, Jasper, 3001 Leuven (BE)
(74) Representative: Roth, Sebastian

(56) References cited:
- WO-A1-2021/112247
- US-A1- 2011 198 725
- US-A1- 2016 064 391
- US-A1- 2019 103 151
- US-B1- 11 423 967

## Description

### TECHNICAL FIELD

The present disclosure relates to the field of capacitor based ferroelectric memories. In particular, the present disclosure relates to a capacitive memory structure, a memory device comprising a plurality of such capacitive memory structures, and a method for reading-out a capacitive memory structure.

### BACKGROUND

A ferroelectric random access memory (FeRAM) uses a ferroelectric layer to store information. FeRAMs often consists of a grid of memory cells, each memory cell comprising a capacitor and a select transistor (so-called 1T-1C devices). The ferroelectric layer is thereby arranged between the capacitor plates.

To read-out the current memory state of such a memory cell, the cell is forced to a known memory state, i.e., to a particular net polarization (up or down) of the ferroelectric. Based on the response of the cell, it is deduced whether the memory state has changed as a result or not. Thus, in 50% of the cases (on average) the current memory state of the cell is overwritten during read-out and the cell needs to be reprogrammed afterwards (so-called destructive read-out). Because of this destructive read-out, the endurance of the cell, i.e., the total number of attainable write/erase cycles, is linked to the number of read cycles. This leads generally to more demanding specifications. For instance, a cell should endure up to 1E13 write/erase cycles or more.

Furthermore, the switching power is determined by the polarization value of the ferroelectric which can be quite high. Since the cells are switched in 50% of all read cycles, reading requires a voltage that is sufficiently high to switch the cell to a known memory state and an additional rewrite cycle both adding to the power consumption.

Finally, the select transistor which is used for decoding of the memory cell in a 1T-1C configuration enhances the size of the memory cell and makes it non-stackable, especially when using silicon transistors.

US 2011198725 A1 discloses an electric component comprising at least one first Metal-insulator-metal (MIM) capacitor having a first capacitor electrode of a first electrode material and a second capacitor electrode of a second electrode material. The first and second electrode materials are selected such that the first MIM capacitor exhibits, as a function of a DC voltage applicable between the first and second electrodes, an asymmetric capacity hysteresis.

WO 2021112247 A1 discloses a non-volatile storage element and a non-volatile storage device that use a ferroelectric material and can be embedded in advanced Complementary Metal-Oxide-Semiconductor (CMOS) logic.

### SUMMARY

Thus, it is an objective to provide an improved capacitive memory structure and an improved method for reading-out a capacitive memory structure. In particular, the above-mentioned disadvantages should be avoided.

The objective is achieved by the embodiments provided in the enclosed independent claims. Advantageous implementations of the embodiments of the invention are further defined in the dependent claims. Only embodiments of the description comprising all the technical features of the claims fall under the scope of protection of the claims while the remaining ones correspond to illustrative examples which are useful for the understanding of the relevant technical context.

According to a first aspect, the present disclosure relates to a capacitive memory structure, comprising: a substrate; a first metallic layer on the substrate; a ferroelectric material layer on the first metallic layer, wherein the ferroelectric material layer is electrically excitable to two polarization states, each polarization state representing a memory state of the capacitive memory structure; and a second metallic layer on the ferroelectric material layer; wherein the first metallic layer and the second metallic layer have different work functions, wherein the ferroelectric material layer comprises hafnium-zirconium oxide (HZO), wherein one of the first metallic layer and the second metallic layer comprises a composition comprising Mo and a molybdenum oxide (MoOx), and wherein the other one of the first metallic layer and the second metallic layer comprises titanium nitride (TiN).

This achieves the advantage that a capacitor based ferroelectric memory structure is provided whose memory can be read out in a non-destructive way.

In particular, the different work functions of the two metallic layers cause an asymmetry of the hysteresis loop of the ferroelectric layer, in particular also an asymmetry of the capacitance-voltage hysteresis. Due to the asymmetry of the capacitance-voltage hysteresis, a capacitance and, thus, a dielectric response of the memory structure differs depending on the current polarization state of the ferroelectric layer even if no bias voltage is applied to the ferroelectric layer. This difference in capacitance (or dielectric response) is also referred to as memory window.

Thus, the current polarization state of the ferroelectric layer can be detected by measuring a dielectric response (e.g., an effective permittivity or capacitance) of the ferroelectric material layer, even if no (or only a small) bias voltage is applied. Hence, a memory state of the memory structure can be read-out without having to "switch" the polarization of the ferroelectric layer (non-destructive read out or NDRO).

The first metallic layer, the ferroelectric material layer and the second metallic layer can form a ferroelectric capacitor. Thereby, the first and second metallic layers can form the capacitor plates of the ferroelectric capacitor.

In particular, the fact that the first and the second metallic layer have different work functions means that they comprise or are formed from materials (or material compositions) with different work functions. For instance, the first metallic layer has a first work function, and the second metallic layer has a second work function which is different from the first work function.

The polarization states to which the ferroelectric material layer can be electrically excited may refer to the "net polarization" of the electric dipoles in the ferroelectric material layer. The two polarization states can be represented as "up" or "down" polarization, wherein one polarization state represents a "0" and the other polarization state represents a "1" or vice versa.

The substrate can be a silicon substrate, in particular a p-doped silicon substrate.

In an embodiment, the work functions of the first metallic layer and the second metallic layer differ by at least 0.3 eV.

In an embodiment, the first metallic layer and the second metallic layer comprise different materials or material compositions.

In an embodiment, the ferroelectric material layer comprises lanthanum doped HZO, La:HZO.

The ferroelectric material layer may comprise any other suitable ferroelectric material, such as hafnium-oxide (HfO2) or lead zirconate titanate (PZT).

In an embodiment, during a read-out of the capacitive memory structure, the first metallic layer and the second metallic layer are configured to apply a DC bias voltage to the ferroelectric material layer, wherein the DC bias voltage is lower than a voltage required to change a current polarization state of the ferroelectric material layer.

The DC bias voltage can additionally increase a difference between the dielectric response of the two polarization states (memory window) of the ferroelectric layer. However, the DC bias voltage can be lower than a voltage required to switch the polarization state of the ferroelectric layer. Thus, the memory state of the memory structure can still be read out in a non-destructive way.

According to a second aspect, the disclosure relates to a memory device, comprising: a plurality of capacitive memory structures according to the first aspect of the disclosure; wherein the capacitive memory structures are arranged in a crossbar array.

In particular, each capacitive memory structure can form a memory cell of the memory devices. The memory device can be a random access memory (RAM) device.

In an example, the memory device can be a selectorless memory device, i.e., the memory cells of the memory device do not comprise an additional select transistor for the capacitor (so-called 0T-1C configuration). This achieves the advantage that the memory cells can be denser and 3D stackable. Furthermore, the memory structure can be back end of line (BEOL) compatible.

According to a third aspect, the disclosure relates to a method for reading-out a capacitive memory structure, wherein the capacitive memory structure comprises a ferroelectric material layer which is arranged between a first metallic layer and a second metallic layer. The method comprises the steps of: applying a DC bias voltage to the ferroelectric material layer by means of the first and the second metallic layer, wherein the DC bias voltage is lower than a voltage required to change a current polarization state of the ferroelectric material layer; detecting a capacitance of the ferroelectric material layer at the bias voltage; and correlating the detected capacitance to the current polarization state of the ferroelectric material layer, wherein the first metallic layer or the second metallic layer comprises a composition comprising Mo and a MoOx.

This achieves the advantage that the memory state of the capacitor based ferroelectric memory structure can be read out in a non-destructive way.

In particular, applying the bias voltage causes or increases a capacitance difference between the two polarization states of the ferroelectric. At the bias voltage, the capacitance-voltage loop of the ferroelectric exhibits a bigger gap (i.e., a bigger memory window) between the capacitance values of the polarization states. This memory window can be used to read-out the polarization state. However, since the bias voltage is still lower than the voltage required to change the current polarization state of the ferroelectric layer, the read-out can be non-destructive to the current memory state.

Here, capacitance of the ferroelectric material layer may refer to the capacitance of the ferroelectric capacitor formed by the ferroelectric material layer and the first and second metallic layers.

Hence, the effect of the bias voltage can be sufficient to cause a detectable difference in the dielectric response of the ferroelectric layer depending on its polarization state that can be read-out in a non-destructive way.

In an embodiment, the first metallic layer and the second metallic layer comprise different materials or material compositions. This achieves the advantage that the difference between the dielectric responses of the two polarization states of the ferroelectric layer can be further enhanced, thus, increasing the "memory window".

The first metallic layer and the second metallic layer have different work functions.

In an embodiment, the work functions of the first metallic layer and the second metallic layer differ by at least 0.3 eV.

In an embodiment, the ferroelectric material layer comprises lanthanum doped HZO, La:HZO.

In an embodiment, the capacitance of the ferroelectric material layer is detected by applying an AC voltage signal to one side of the ferroelectric material layer and detecting a dielectric response of the ferroelectric material layer by means of the AC voltage signal at the other side of the ferroelectric material layer.

The dielectric response can comprise a displacement current which is generated after a build-up of a displacement charge due to the AC voltage signal.

The AC voltage signal (e.g., 30 mV or 100 mV pulses) can be applied to one of the metallic layers, in particular to the metallic layer that is connected to a word line, and can cause the build-up of a displacement charge in the capacitive memory structure. The dielectric response can be detected on a bit line that is connected to the respective other metallic layer.

### BRIEF DESCRIPTION OF THE DRAWINGS

Embodiments of the invention will be explained in the followings together with the figures.
- Fig. 1: shows a schematic diagram of a capacitive memory structure according to an embodiment;
- Figs. 2A-B: show diagrams of capacitance-voltage characteristics of different capacitive memory structures according to an embodiment;
- Figs. 3A-C: show diagrams of measurements with a capacitive memory structure according to an embodiment;
- Fig. 4: shows diagrams of measurements with different capacitive memory structures according to an embodiment;
- Figs. 5A-B: show diagrams of measurements with different capacitive memory structures according to an embodiment;
- Fig. 6: shows a schematic diagram of a memory device according to an embodiment; and
- Fig. 7: shows a flow diagram of a method for reading-out a capacitive memory structure according to an embodiment.

### DETAILED DESCRIPTION OF THE PREFERRED EMBODIMENTS

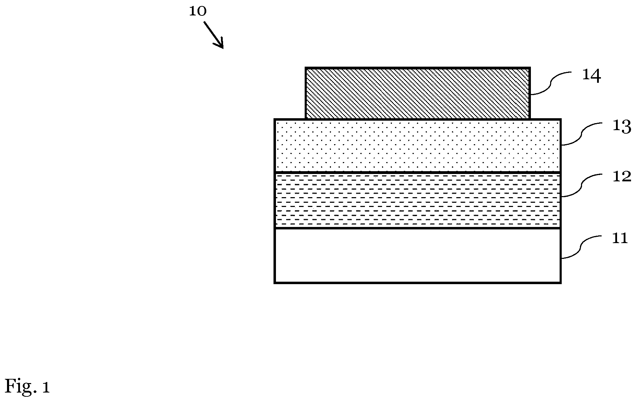

Fig. 1 shows a schematic diagram of a capacitive memory structure 10 according to an embodiment.

The capacitive memory structure 10 comprises a substrate 11, a first metallic layer 12 on the substrate 11, a ferroelectric material layer 13 on the first metallic layer 12, and a second metallic layer 14 on the ferroelectric material layer 13, wherein the first metallic layer 12 and the second metallic layer 13 have different work functions. The ferroelectric material layer 13 is electrically excitable to two polarization states, each polarization state representing a memory state of the capacitive memory structure.

Thereby, the different work functions of the two metallic layers 12, 14 cause an asymmetry of a capacitance-voltage characteristic (hysteresis) of the ferroelectric material layer 13. This asymmetry causes a difference in capacitance value of the ferroelectric material layer 13 depending on its polarization which can be used for a non-destructive read-out of the memory structure 10.

In particular, the metallic layers 12, 14 are capacitor plates of the capacitive memory structure 10. They can be configured to apply a voltage, e.g. a read/write voltage or a bias voltage, to the ferroelectric material layer 10. The metallic layers 12, 14 and the ferroelectric material layer 13 can form a ferroelectric capacitor.

Preferably, the work functions of the first metallic layer 12 and the second metallic layer 14 can differ by at least 0.3 eV. This achieves the advantage that a sufficient difference in the dielectric response between the two polarization states of the ferroelectric layer 13, i.e. a sufficiently big memory window, is achieved, even at zero or very low bias voltages.

The first metallic layer 12 and the second metallic layer 14 may comprise different materials or material compositions. In particular, these different material or material compositions can have different work functions, causing the asymmetry of the capacitance-voltage characteristic of the ferroelectric capacitor.

For example, the first metallic layer 12 and the second metallic layer 14 can be formed from different work function metals.

The first metallic layer 12 or the second metallic layer 14 comprises a composition comprising Mo and a MoOx.

The first metallic layer 12 and/or the second metallic layer 14 may comprise any one of the following materials or material compositions: molybdenum (Mo), titanium nitride (TiN), a composition comprising ruthenium (Ru) and TiN, or tungsten (W).

The ferroelectric material layer 13 can comprise hafnium-zirconium oxide (HZO or HfZrO₄), in particular lanthanum doped HZO (La:HZO). Besides HZO, the ferroelectric material layer 13 may comprise or be formed from any other suitable ferroelectric material, such as hafnium-oxide (HfO2) or lead zirconate titanate (PZT).

For instance, the ferroelectric material layer 13 has a thickness of 10 nm.

The substrate 11 can be a silicon (Si) substrate, in particular a p-doped Si substrate. The substrate can be a p⁺⁺ <Si> substrate.

In particular, the substrate can be any suitable substrate and can comprise further material layers. For instance, in the back end of line (BEOL), the bottom electrode (layer 11) could be partially deposited on an oxide and/or on a metal that connects the bottom electrode to a contact, e.g., via a further layer.

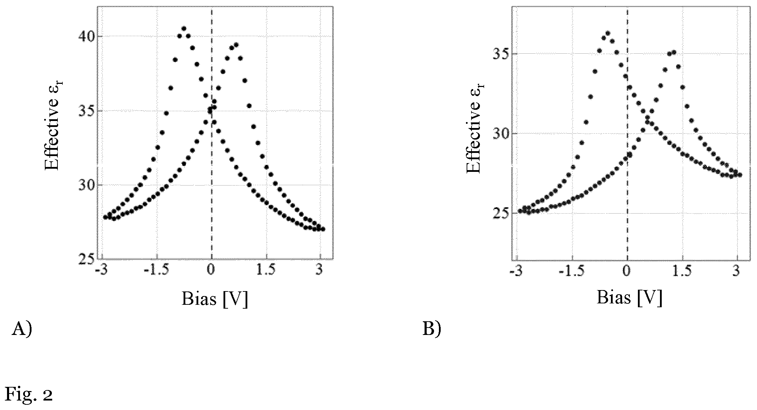

Figs. 2A-B show diagrams of capacitance-voltage (C-V) characteristics of different capacitive memory structures according to an embodiment. Thereby, the x-axes of the diagrams show a bias voltage that is applied to the ferroelectric material layer and the y-axes shows the effective permittivity of the ferroelectric (which is linearly related to the capacitance). The curves in Figs. 2A-B can, thus, also be referred to as epsilon bias curves.

Fig. 2A shows the C-V characteristic of a symmetric capacitive memory structure where a ferroelectric material layer, e.g. an HZO layer, is arranged between two metallic layers having the same work functions, e.g. two TiN layers. Due to its shape, the C-V curve (or epsilon bias curve) in Fig. 2A is also referred to as butterfly curve. This shape is caused by the hysteresis of the ferroelectric.

The characteristic C-V curve in Fig. 2A is symmetrical around a bias voltage of 0 V. This means that at 0 V (no bias voltage), the memory structure 10 has the same capacitance for both possible polarization states (i.e., for both memory states). At bias voltages of circa +1 V respectively-1 V, the polarization state of the ferroelectric material layer switches, as is visible by the respective peaks in the butterfly curve.

Fig. 2B shows the C-V characteristic of an asymmetric capacitive memory structure 10 as shown in Fig. 1, where the ferroelectric material layer 13 is arranged between two metallic layers 12, 14 which have different work function values. For instance, the first metallic layer 12 is formed from an Mo, MoOx composition, the second metallic layer 14 is formed from TiN, and the ferroelectric material layer 13 is formed from La:HZO.

As it can be seen in Fig. 2B, the asymmetry of the metallic layers 12, 14 on both sides of the ferroelectric material layer 13 causes an asymmetry in the butterfly curve. At a bias voltage of 0 V, the capacitance of the ferroelectric material layer differs depending on the polarization state of the ferroelectric (e.g., up or down).

Thus, by using an asymmetrical capacitor (i.e., by using two different work function metal layers 12, 14 on either side of the ferroelectric material layer 13), an asymmetry in the epsilon bias butterfly curve can be created which allows to detect the polarization state of the capacitor without switching (non-destructive read out). This allows for very low power (deep low power mode) nonvolatile memory elements which exhibit very high read endurance and are suitable for selectorless operation.

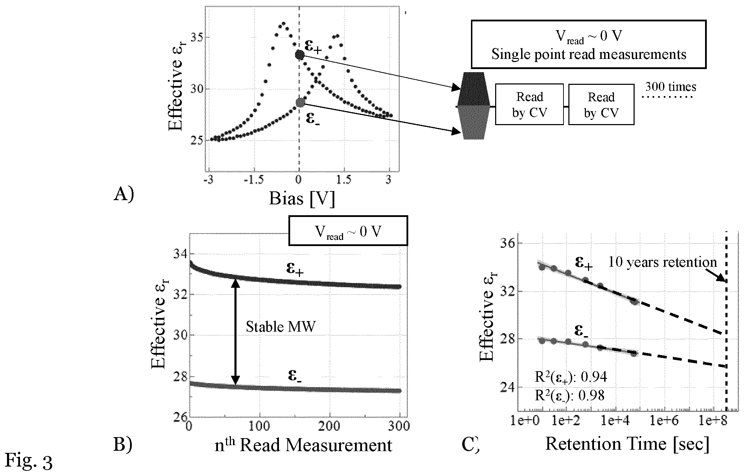

Figs. 3A-C show diagrams of measurements with the capacitive memory structure 10 according to an embodiment. The measurements are performed on the same asymmetric memory structure 10 as the measurement shown in Fig. 2B.

Fig. 3A shows again the C-V characteristic, wherein the effective permittivity values of the ferroelectric material in the first polarization state (ε₊) and in the second polarization state (ε₋) at zero bias voltage are highlighted. The difference between ε₊ and ε₋ defines a memory window (MW) of the memory structure 10. Due to this memory window, it is possible to read data without switching/disturbing the polarization states at zero DC voltage bias.

The effective permittivity (ε₊ or e-) of the ferroelectric material layer 13 can be read out by applying a low AC voltage signal, e.g. 30 mV, to one of the metallic layers 12, 14 and observing a response at the respective other metallic layer 12, 14. In a memory device, for instance, one metallic layer 12, 14 is connected to a word line and the other metallic layer 12, 14 is connected to a bit line. Thus, the memory state can be read-out without switching/disturbing the polarization states.

In particular, the AC voltage signal can be applied to the capacitive memory structure 10 in the form of pulses which cause the build-up of a displacement charge. When the capacitive memory structure 10 subsequently discharges, a displacement current is generated which can be measured. Based on this displacement current, the capacitance and, thus, the polarization state (memory state) of the memory structure can be detected.

Fig. 3B shows the result of ca. 300 consecutive measurements of ε₊ and ε₋ at zero bias voltage (V_{read} ~ 0 V). These measurements show that the memory window (MW), i.e. the difference between ε₊ and ε₋ stays relatively constant over time with only a slight reduction after the first measurements.

In particular, the fact that the memory structure can be read-out in a non-destructive way causes the endurance specification of the memory structure to be determined by the write cycles requirement and not by the read cycles. Furthermore, the power consumption can be much lower as only a displacement current from the paraelectric response of the ferroelectric to the AC signal is required without actually switching the ferroelectric.

Fig. 3C shows measured retention times at the memory states ε₊ and ε₋. These measurements show that good retention times > 1.000 sec can be achieved.

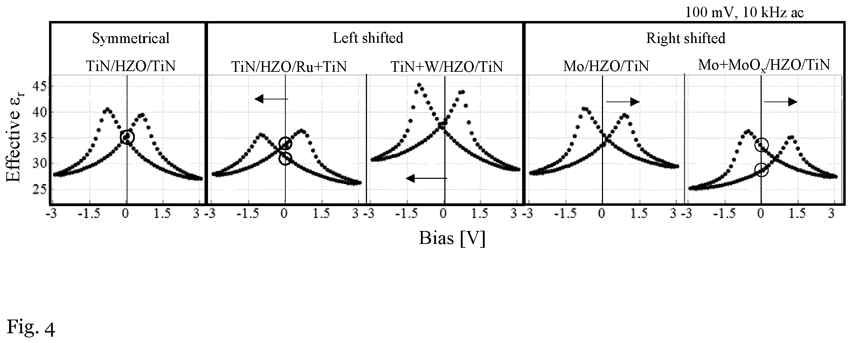

Fig. 4 shows diagrams of measurements with different capacitive memory structures according to an embodiment. In particular, Fig. 4 compares the C-V characteristics (butterfly curves) of symmetric and asymmetric capacitive memory structures. The measurements were carried out with an AC signal of 100 mV at 10 kHz.

The first butterfly curve is measured with a symmetric TiN/HZO/TiN (HZO ferroelectric between two TiN layers) capacitive memory structure. This symmetric structure yields a symmetric butterfly curve.

The next two butterfly curves are measured with asymmetric capacitive memory structures 10, namely a TiN/HZO/Ru+TiN structure and a TiN+W/HZO/TiN structure. The butterfly curve of both structures is displaced to the left (towards negative voltage), wherein the displacement is bigger for the TiN/HZO/Ru+TiN structure causing a noticeable memory window at zero voltage bias (highlighted by two circles).

The last two butterfly curves are also measured with asymmetric capacitive memory structures 10, namely a Mo/HZO/TiN structure and a Mo+MoOx/HZO/TiN structure. The butterfly curves of both structures are displaced to the right (towards positive voltage), wherein the displacement is bigger for the Mo+MoOx/HZO/TiN structure causing a noticeable memory window at zero voltage bias (highlighted by two circles).

The measurements depicted in Fig. 4 show that memory windows at zero voltage bias can be achieved with different material combinations of the metallic layers 12, 14, wherein the size of the memory window can be adjusted to some degree by a suitable choice of material.

5A-B show diagrams of measurements with different capacitive memory structures according to an embodiment.

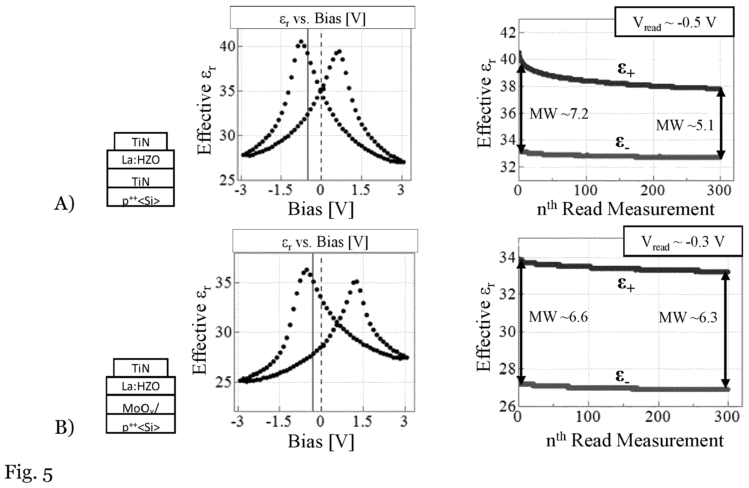

The measurements shown in Fig. 5A were performed on a symmetric capacitive memory structure comprising a La:HZO ferroelectric layer between two TiN metallic layers. This memory structure yields a symmetric C-V characteristic (butterfly curve) which has no memory window at zero voltage bias. To perform a non-destructive read-out, a bias DC voltage of V_{read} ~ -0.5 V was applied to the ferroelectric layer by means of the TiN metallic layers. As it can be seen in the C-V characteristic, at this bias voltage the effective permittivity corresponding to positive and negative polarization states are not equal, the difference results in a non-zero memory window (MW).

At the same time, the bias voltage of 0.5 V is lower than a voltage that would be required to change the current polarization state of the ferroelectric material layer. Thus, by applying a bias voltage of -0.5 V, the memory structure can be read-out in a non-destructive way using the above approach.

The right diagram in Fig. 5A shows the result of ca. 300 consecutive measurements of the polarization states ε₊ and ε₋ at the non-zero DC read voltage -0.5 V. The memory window slightly drops to ca. 7.2 to 5.1 but stays large enough to enable a non-destructive read-out.

The measurements shown in Fig. 5B were performed on an asymmetric capacitive memory structure 10 comprising a La:HZO ferroelectric layer between an MoOx/M metallic layer and a TiN metallic layer. Due to the different work functions of the metallic layers, the butterfly curve is asymmetric, causing a non-zero memory window at zero voltage bias.

As it can be seen in Fig. 5B, the memory window can be further increased by applying a bias voltage to the ferroelectric material layer 13. The bias voltage is, thereby, again lower than a voltage required to switch the memory state.

The right diagram in Fig. 5B shows the result of ca. 300 consecutive measurements of the polarization states ε₊ and ε₋ at the non-zero DC read voltage -0.3 V on the asymmetric memory structure 10. These measurements show an initial memory window of ca. 6.6 which only drops by a value of ca. 0.3 after 300 measurements. Thus, by combining an asymmetric memory structure 10 with a non-zero DC bias voltage (which is smaller than a voltage required to switch the memory state), a capacitive memory structure 10 with a stable memory window can be created, which can be read-out in a non-destructive way.

In summary, a difference in the capacitance value for the two polarization states of the ferroelectric material (so-called memory window) can be generated by utilizing a variation in the dielectric response of the ferroelectric that occurs before it switches its polarization state. In this way, the polarization state can be read-out in a non-destructive way. To generate this memory window, the symmetry of the system can be broken by, e.g., using different work function metals on both sides of the ferroelectric, eventually aided by the use of asymmetrical write/erase voltages and/or by the application of a DC bias during read-out.

In the measurements shown in Figs. 5A and 5B, DC bias voltages of -500mV respectively -300mV are applied to the ferroelectric material layer. These values serve as examples for possible non-zero read-out voltages. Other DC bias voltages (which are lower than the voltage required to change the polarization state of the ferroelectric material layer) could be chosen.

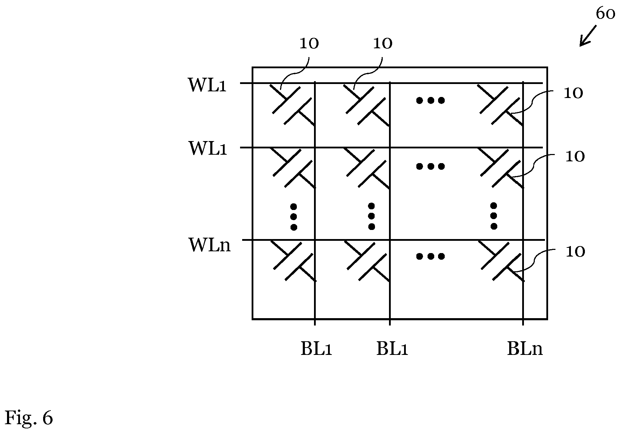

Fig. 6 shows a schematic diagram of a memory device 60 according to an embodiment.

The memory device 60 comprises a plurality of capacitive memory structures 10 as shown in any one of Figs. 1, 4, or 5A-B. The capacitive memory structures 10 are arranged in a crossbar array.

Preferably, the capacitive memory structures 10 of the memory device 60 can form a selectorless, capacitor-only array (0T-1C array), i.e. a memory array without select transistors. This is possible because, the capacitor structures 10 do not have to be switched during read-out, which allows to remove the select transistor. Therefore, the capacitive memory structures 10 can be arranged densely and can be 3D stackable.

Sensing of the memory states can be done by an AC voltage signal on the word lines WL1, ..., WLn which are connected to one side of the capacitive memory structures 10 and detecting a dielectric response on the bit lines BL1, ..., BLn (connected to the other side of the capacitive memory structures 10). In this way, a very compact memory array can be generated which can be built entirely in the back-end of the process and therefore can be evenly stacked. This can reduce the cost of the memory array.

In particular, the capacitive memory structures 10 form memory cells of the memory device 60. Compared to conventional memory cells that use resistive elements (e.g., resistive RAM, Phase Change cells, MRAM), the capacitive memory structures 10 do not require an active current which strongly reduces their power consumption. The displacement current that can be used to read-out the memory structures can be much lower than an active current in conventional memories and can run only for a limited time during read-out. Thus, the memory structures 10 can be superior for computing-in-memory (CiM) applications which require large memory arrays.

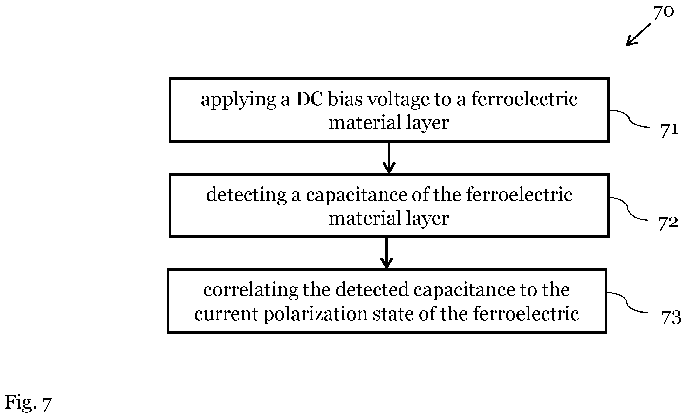

Fig. 7 shows a flow diagram of a method 70 for reading-out a capacitive memory structure according to an embodiment. Thereby, the capacitive memory structure comprises a ferroelectric material layer which is arranged between a first metallic layer and a second metallic layer.

The method 70 comprises the steps of: applying 71 a DC bias voltage to the ferroelectric material layer by means of the first and the second metallic layer, wherein the DC bias voltage is lower than a voltage required to change a current polarization state of the ferroelectric material layer; detecting 72 a capacitance of the ferroelectric material layer at the bias voltage; and correlating 73 the detected capacitance to the current polarization state of the ferroelectric material layer.

The capacitive memory structure can be any one of the structures shown or disclosed in Figs. 1, 4 and 5. In particular, the first metallic layer and the second metallic layer of the metallic memory structure can be formed from the same material or material composition, as e.g. shown in Fig. 4 (1^{st} curve) or Fig. 5A.

Alternatively, the first metallic layer and the second metallic layer can comprise different materials or material compositions, as e.g. shown in Fig. 1, 4 (2^{nd} to 5^{th} curve) or 5B. In particular, the first metallic layer and the second metallic layer have different work functions. Preferably, their work functions differ by at least 0.3 V.

The first metallic layer and/or the second metallic layer may comprise any one of the following materials or material compositions: Mo, MoOx, TiN, Ru and TiN, or W. The ferroelectric material layer may comprise HZO, in La:HZO.

The capacitance of the ferroelectric material layer can be detected 72 by applying an AC voltage signal to one side of the ferroelectric material layer and detecting a dielectric response of the ferroelectric material layer to the AC voltage signal at the other side of the ferroelectric material layer.

## Claims

1. A capacitive memory structure (10), comprising:
a substrate (11);
a first metallic layer (12) on the substrate;
a ferroelectric material layer (13) on the first metallic layer (12), wherein the ferroelectric material layer (13) comprises hafnium-zirconium oxide, HZO, and is electrically excitable to two polarization states, each polarization state representing a memory state of the capacitive memory structure (10); and
a second metallic layer (14) on the ferroelectric material layer (13);
wherein the first metallic layer (12) and the second metallic layer (14) have different work functions,
wherein one of the first metallic layer (12) and the second metallic layer (14) comprises a composition comprising Mo and a molybdenum oxide, MoOx, and
wherein the other one of the first metallic layer (12) and the second metallic layer (14) comprises titanium nitride, TiN.

2. The capacitive memory structure (10) of claim 1,
wherein the work functions of the first metallic layer (12) and the second metallic layer (14) differ by at least 0.3 eV.

3. The capacitive memory structure (10) of claim 1 or 2,
wherein the first metallic layer (12) and the second metallic layer (14) comprise different materials or material compositions.

4. The capacitive memory structure (10) of any one of the preceding claims,
wherein the ferroelectric material layer (13) comprises lanthanum doped HZO, La:HZO.

5. The capacitive memory structure (10) of any one of the preceding claims,
wherein, during a read-out of the capacitive memory structure (10), the first metallic layer (12) and the second metallic layer (14) are configured to apply a DC bias voltage to the ferroelectric material layer (13), wherein the DC bias voltage is lower than a voltage required to change a current polarization state of the ferroelectric material layer (13).

6. A memory device (60), comprising:
a plurality of capacitive memory structures (10) of any one of the preceding claims;
wherein the capacitive memory structures (10) are arranged in a crossbar array.

7. A method (70) for reading-out a capacitive memory structure, wherein the capacitive memory structure comprises a ferroelectric material layer which is arranged between a first metallic layer and a second metallic layer, wherein the ferroelectric material layer comprises hafnium-zirconium oxide, HZO,
the method comprising:
applying (71) a DC bias voltage to the ferroelectric material layer by means of the first and the second metallic layer, wherein the DC bias voltage is lower than a voltage required to change a current polarization state of the ferroelectric material layer;
detecting (72) a capacitance of the ferroelectric material layer at the bias voltage; and
correlating (73) the detected capacitance to the current polarization state of the ferroelectric material layer,
wherein the first metallic layer and the second metallic layer have different work functions,
wherein one of the first metallic layer and the second metallic layer comprises a composition comprising Mo and a molybdenum oxide, MoOx, and
wherein the other one of the first metallic layer and the second metallic layer comprises titanium nitride, TiN.

8. The method (70) of claim 7,
wherein the first metallic layer and the second metallic layer comprise different materials or material compositions.

9. The method (70) of any one of claims 7 or 8,
wherein the work functions of the first metallic layer and the second metallic layer differ by at least 0.3 eV.

10. The method (70) of any one of claims 7 to 9,
wherein the ferroelectric material layer comprises lanthanum doped HZO, La:HZO.

11. The method (70) of any one of claims 7 to 10,
wherein the capacitance of the ferroelectric material layer is detected (72) by applying an AC voltage signal to one side of the ferroelectric material layer and detecting a dielectric response of the ferroelectric material layer by means of the AC voltage signal at the other side of the ferroelectric material layer.

## Patentansprüche

1. Kapazitive Speicherstruktur (10), umfassend:
ein Substrat (11);
eine erste Metallschicht (12) auf dem Substrat;
eine ferroelektrische Materialschicht (13) auf der ersten Metallschicht (12), wobei die ferroelektrische Materialschicht (13) Hafnium-Zirkoniumoxid (HZO) umfasst und elektrisch in zwei Polarisationszustände anregbar ist, wobei jeder Polarisationszustand einen Speicherzustand der kapazitiven Speicherstruktur (10) repräsentiert; und
eine zweite Metallschicht (14) auf der ferroelektrischen Materialschicht (13);
wobei die erste Metallschicht (12) und die zweite Metallschicht (14) eine unterschiedliche Austrittsarbeit aufweisen,
wobei eine der ersten Metallschicht (12) und der zweiten Metallschicht (14) eine Zusammensetzung umfasst, die Mo und ein Molybdänoxid, MoOx, umfasst, und wobei die andere der ersten Metallschicht (12) und der zweiten Metallschicht (14) Titannitrid, TiN, umfasst.

2. Kapazitive Speicherstruktur (10) nach Anspruch 1,
wobei sich die Austrittsarbeit der ersten Metallschicht (12) und der zweiten Metallschicht (14) um mindestens 0,3 eV unterscheidet.

3. Kapazitive Speicherstruktur (10) nach Anspruch 1 oder 2,
wobei die erste Metallschicht (12) und die zweite Metallschicht (14) unterschiedliche Materialien oder Materialzusammensetzungen umfassen.

4. Kapazitive Speicherstruktur (10) nach einem der vorhergehenden Ansprüche,
wobei die ferroelektrische Materialschicht (13) mit Lanthan dotiertes HZO, La:HZO, umfasst.

5. Kapazitive Speicherstruktur (10) nach einem der vorhergehenden Ansprüche,
wobei während eines Auslesens der kapazitiven Speicherstruktur (10) die erste Metallschicht (12) und die zweite Metallschicht (14) so konfiguriert sind, dass sie eine Gleichvorspannung an die ferroelektrische Materialschicht (13) anlegen, wobei die Gleichvorspannung niedriger ist als eine Spannung, die erforderlich ist, um einen aktuellen Polarisationszustand der ferroelektrischen Materialschicht (13) zu ändern.

6. Speichervorrichtung (60), umfassend:
eine Vielzahl kapazitiver Speicherstrukturen (10) nach einem der vorhergehenden Ansprüche;
wobei die kapazitiven Speicherstrukturen (10) in einer Kreuzschienenanordnung angeordnet sind.

7. Verfahren (70) zum Auslesen einer kapazitiven Speicherstruktur, wobei die kapazitive Speicherstruktur eine ferroelektrische Materialschicht umfasst, die zwischen einer ersten Metallschicht und einer zweiten Metallschicht angeordnet ist, wobei die ferroelektrische Materialschicht Hafnium-Zirkoniumoxid (HZO) umfasst,
wobei das Verfahren umfasst:
Anlegen (71) einer Gleichvorspannung an die ferroelektrische Materialschicht mittels der ersten und der zweiten Metallschicht, wobei die Gleichvorspannung niedriger ist als eine Spannung, die erforderlich ist, um einen aktuellen Polarisationszustand der ferroelektrischen Materialschicht zu ändern;
Erkennen (72) einer Kapazität der ferroelektrischen Materialschicht bei der Vorspannung; und
Korrelieren (73) der erkannten Kapazität mit dem aktuellen Polarisationszustand der ferroelektrischen Materialschicht,
wobei die erste Metallschicht und die zweite Metallschicht eine unterschiedliche Austrittsarbeit aufweisen,
wobei eine der ersten Metallschicht und der zweiten Metallschicht eine Zusammensetzung umfasst, die Mo und ein Molybdänoxid, MoOx, umfasst, und
wobei die andere der ersten Metallschicht und der zweiten Metallschicht Titannitrid, TiN, umfasst.

8. Verfahren (70) nach Anspruch 7,
wobei die erste Metallschicht und die zweite Metallschicht unterschiedliche Materialien oder Materialzusammensetzungen umfassen.

9. Verfahren (70) nach einem der Ansprüche 7 oder 8,
wobei sich die Austrittsarbeit der ersten Metallschicht und der zweiten Metallschicht um mindestens 0,3 eV unterscheidet.

10. Verfahren (70) nach einem der Ansprüche 7 bis 9,
wobei die ferroelektrische Materialschicht mit Lanthan dotiertes HZO, La:HZO, umfasst.

11. Verfahren (70) nach einem der Ansprüche 7 bis 10,
wobei die Kapazität der ferroelektrischen Materialschicht erkannt (72) wird, indem ein Wechselspannungssignal an eine Seite der ferroelektrischen Materialschicht angelegt wird und eine dielektrische Reaktion der ferroelektrischen Materialschicht mittels des Wechselspannungssignals an der anderen Seite der ferroelektrischen Materialschicht erkannt wird.

## Revendications

1. Structure de mémoire capacitive (10), comprenant :
un substrat (11) ;
une première couche métallique (12) sur le substrat ;
une couche de matériau ferroélectrique (13) sur la première couche métallique (12), la couche de matériau ferroélectrique (13) comprenant de l'oxyde de hafnium-zirconium, HZO, et étant électriquement excitable vers deux états de polarisation, chaque état de polarisation représentant un état de mémoire de la structure de mémoire capacitive (10) ; et
une deuxième couche métallique (14) sur la couche de matériau ferroélectrique (13) ;
dans laquelle la première couche métallique (12) et la deuxième couche métallique (14) présentent des travaux d'extraction différents,
dans laquelle une couche parmi la première couche métallique (12) et la deuxième couche métallique (14) comprend une composition comprenant du Mo et un oxyde de molybdène, MoOx, et
dans laquelle l'autre couche parmi la première couche métallique (12) et la deuxième couche métallique (14) comprend du nitrure de titane, TiN.

2. Structure de mémoire capacitive (10) de la revendication 1,
dans laquelle les travaux d'extraction de la première couche métallique (12) et de la deuxième couche métallique (14) diffèrent d'au moins 0,3 eV.

3. Structure de mémoire capacitive (10) de la revendication 1 ou 2,
dans laquelle la première couche métallique (12) et la deuxième couche métallique (14) comprennent des matériaux différents ou des compositions de matière différentes.

4. Structure de mémoire capacitive (10) de l'une quelconque des revendications précédentes,
dans laquelle la couche de matériau ferroélectrique (13) comprend du HZO dopé au lanthane, La:HZO.

5. Structure de mémoire capacitive (10) de l'une quelconque des revendications précédentes,
dans laquelle, pendant une lecture de la structure de mémoire capacitive (10), la première couche métallique (12) et la deuxième couche métallique (14) sont conçues pour appliquer une tension de polarisation CC à la couche de matériau ferroélectrique (13), la tension de polarisation CC étant inférieure à une tension nécessaire pour modifier un état de polarisation en cours de la couche de matériau ferroélectrique (13).

6. Dispositif de mémoire (60), comprenant :
une pluralité de structures de mémoire capacitive (10) de l'une quelconque des revendications précédentes ;
dans lequel les structures de mémoire capacitive (10) sont disposées selon un réseau de barres croisées.

7. Procédé (70) destiné à lire une structure de mémoire capacitive, la structure de mémoire capacitive comprenant une couche de matériau ferroélectrique qui est disposée entre une première couche métallique et une deuxième couche métallique, la couche de matériau ferroélectrique comprenant de l'oxyde de hafnium-zirconium, HZO,
le procédé comprenant :
l'application (71) d'une tension de polarisation CC à la couche de matériau ferroélectrique au moyen de la première et la deuxième couche métallique, la tension de polarisation CC étant inférieure à une tension nécessaire pour modifier un état de polarisation en cours de la couche de matériau ferroélectrique ;
la détection (72) d'une capacité de la couche de matériau ferroélectrique à la tension de polarisation ; et
la corrélation (73) de la capacité détectée avec l'état de polarisation en cours de la couche de matériau ferroélectrique,
dans lequel la première couche métallique et la deuxième couche métallique présentent des travaux d'extraction différents,
dans lequel une couche parmi la première couche métallique et la deuxième couche métallique comprend une composition comprenant du Mo et un oxyde de molybdène, MoOx, et
dans lequel l'autre couche parmi la première couche métallique et la deuxième couche métallique comprend du nitrure de titane, TiN.

8. Procédé (70) de la revendication 7,
dans lequel la première couche métallique et la deuxième couche métallique comprennent des matériaux différents ou des compositions de matière différentes.

9. Procédé (70) de l'une quelconque des revendications 7 et 8,
dans lequel les travaux d'extraction de la première couche métallique et de la deuxième couche métallique diffèrent d'au moins 0,3 eV.

10. Procédé (70) de l'une quelconque des revendications 7 à 9,
dans lequel la couche de matériau ferroélectrique comprend du HZO dopé au lanthane, La:HZO.

11. Procédé (70) de l'une quelconque des revendications 7 à 10,
dans lequel la capacité de la couche de matériau ferroélectrique est détectée (72) par application d'un signal de tension CA à un côté de la couche de matériau ferroélectrique et détection d'une réponse diélectrique de la couche de matériau ferroélectrique au moyen du signal de tension CA sur l'autre côté de la couche de matériau ferroélectrique.
